Europäisches Patentamt

European Patent Office

Office européen des brevets

(19)

(11) **EP 1 349 269 A1**

(12) **EUROPEAN PATENT APPLICATION**

(43) Date of publication:
**01.10.2003 Bulletin 2003/40**

(51) Int Cl.[7]: **H03G 3/00**, H03G 3/30

(21) Application number: **02007188.2**

(22) Date of filing: **28.03.2002**

| | |
|---|---|
| (84) Designated Contracting States:<br>**AT BE CH CY DE DK ES FI FR GB GR IE IT LI LU<br>MC NL PT SE TR**<br>Designated Extension States:<br>**AL LT LV MK RO SI** | (72) Inventor: **Rauch, Stefan**<br>**c/o Sony International (Europe) GmbH**<br>**85609 Aschheim-Dornach (DE)** |
| (71) Applicant: **Sony International (Europe) GmbH**<br>**10785 Berlin (DE)** | (74) Representative: **Körber, Martin, Dipl.-Phys.**<br>**Mitscherlich & Partner**<br>**Patentanwälte**<br>**Sonnenstrasse 33**<br>**80331 München (DE)** |

(54) **Rf output power control for mobile phones with a variable dc/dc converter**

(57) The present invention provides a high-frequency power amplification circuit for a mobile terminal to be used in a wireless telecommunication system, with a high-frequency transmit power amplifier (1) operated across a DC operating voltage $V_{cc}$ for amplifying a high-frequency input signal ($RF_{in}$) of input power $P_{in}$ into a high-frequency output signal ($RF_{out}$) of output power $P_{out}$, and a variable DC/DC converter (4) for converting a DC input voltage $V_{bat}$ into a DC output voltage according to a first control signal $V_{ctr}$ applied to a control terminal of the same, wherein the output power $P_{out}$ of the high-frequency transmit power amplifier (1) is controlled by said first control signal $V_{ctr}$ regulating the DC output voltage of the variable DC/DC converter (4) provided to the high-frequency transmit power amplifier (1) as operating voltage $V_{cc}$.

Figure 2

EP 1 349 269 A1

**Description**

The present invention relates to a regulation of the high-frequency (RF) transmission power of mobile terminals for wireless telecommunication systems, in particular to a regulation using the operation voltage dependency of the output power of a high-frequency transmit power amplifier.

The high-frequency (RF) output power of a conventional mobile terminal for a wireless telecommunication system is usually controlled by either the supply voltage $V_{cc}$ of the transmission power amplifier or by means of a gate power control with a control voltage $V_g$ applied to a respective terminal of the power amplifier.

For controlling the RF output power by means of the supply voltage $V_{cc}$ usually MOS (metal oxide on semiconductor) devices are used to reduce the voltage $V_{bat}$ supplied from a constant DC voltage supply like e. g. a mobile terminal's battery pack. The respective MOS device is placed between the constant DC voltage supply $V_{bat}$, which will further be referred to as battery voltage, and the supply voltage $V_{cc}$ terminal of the power amplifier as shown in Fig. la. The power amplifier will with this type of control circuit always be operated in saturation, thus guaranteeing a maximum efficiency over a wide range of RF output power. Further advantages of the described type of RF power control are its relative low cost of production and its smooth control characteristic. One of the disadvantages is, that the maximum achievable RF output power is limited by the battery voltage, because the supply voltage $V_{cc}$ cannot exceed the battery voltage $V_{bat}$.

Although the power amplifier is operated with maximum efficiency for the given circuit example, the MOS device causes considerable power losses. The power loss in the MOS device is given by the product of the voltage drop across the device and the supply current for the power amplifier. The voltage drop is indirect proportional to the adjusted relative value of $V_{cc}$ as compared to the battery voltage. Thus the overall efficiency for this type of a transmission section is particularly poor at low RF output powers reducing a mobile terminal's potential on-air time.

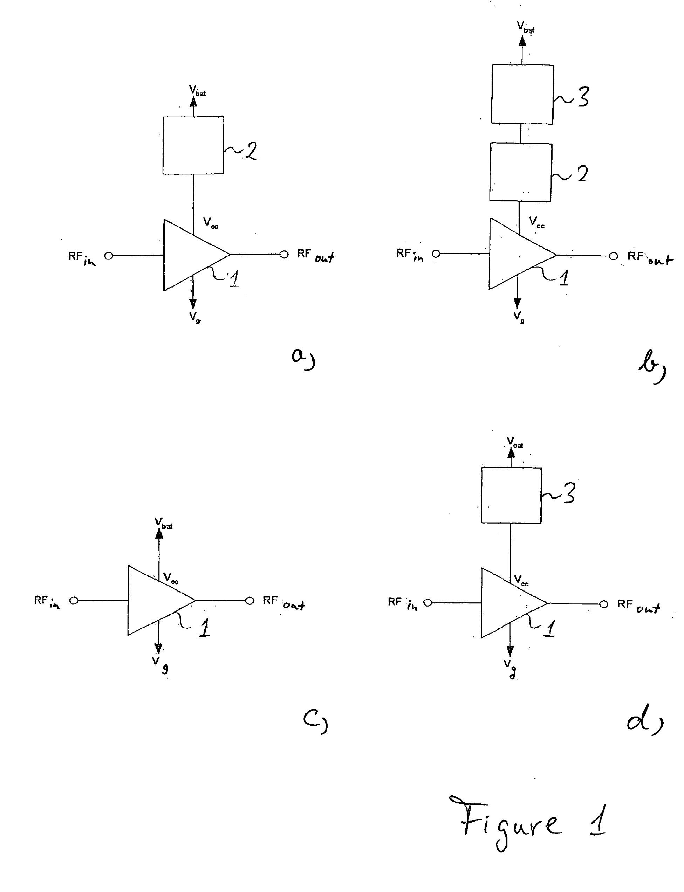

Using a fixed DC/DC converter overcomes the mentioned limitation for the maximum achievable RF output power by the battery voltage, particularly using a boost or step-up converter, respectively, in the DC voltage supply line from the battery pack to the power amplifier as shown in Fig. 1b. A regulation of the RF power is hereby achieved as before by a MOS device, placed in series with the fixed DC/DC converter. Due to the easy current sensing provided by the MOS device, there are no insertion losses in the RF path in this circuit layout. Further, simple and cheap power amplifiers, which can only be operated at supply voltages around 5 V to 6 V can hereby be used with usual battery packs having a battery voltage $V_{bat}$ of 3.6 V to 3.8 V. The achieved control characteristic is smooth, thus enabling a precise and reliable RF output power control. The cost of implementing a respective RF output power control are, due to the cost of the fixed DC/DC converter, relatively high. For low RF output powers, the use of a MOS device for controlling the supply voltage $V_{cc}$ results, like for the power control circuit discussed above in a considerable loss of DC power, reducing the overall efficiency for this type of transmission circuit.

A very common method for controlling the RF output power of a transmission stage of a mobile terminal is to use the Automatic Power Control terminal of a respective power amplifier. By applying an appropriate voltage $V_g$ to the Automatic Power Control terminal, a gate power control is effected regulating the RF output power. A simple example for this type of transmission power control is given in Fig. 1c. The power amplifier is operated across a supply voltage $V_{bat}$ provided from a battery pack of the mobile terminal. A gate power control voltage $V_g$ is applied to the Automatic Power Control terminal of the power amplifier. The value of $V_g$ is indicative of the desired RF output power produced by the power amplifier PA. The circuit design shown can be put into practice at very low production cost, but the achievable maximum output power is again limited by the battery voltage $V_{bat}$, and for low output powers, the power amplifier PA is not operated in saturation, thus working with a very poor efficiency. The control response for this circuit design is very steep, requiring a precisely working control circuit.

As for the example of Fig. 1b, the mentioned limitation of the maximum achievable output power can be overcome by using a fixed DC/DC converter in the supply line from the battery pack to upscale the voltage $V_{bat}$ from the battery to a power supply voltage $V_{cc}$ of higher value. As for the simpler design shown in Fig. 1c, a steep control response characteristic and a poor efficiency at low RF output powers have to be considered as the main disadvantages of this circuit design. The use of the fixed DC/DC converter further means, that a respective transmission circuit can only be produced at relatively high costs. With an appropriately designed fixed DC/DC converter, a high enough supply voltage $V_{cc}$ can be produced to achieve the maximum RF power possible for a respective power amplifier. Furthermore, the DC/DC converter enables an easy current sensing, so that no insertion losses in the RF path have to be taken into account.

As the supply voltage $V_{cc}$ can be adapted to the specification of a power amplifier, cheaper and simpler power amplifier technologies can be used for the technical implementation.

All the conventional transmission circuit designs for mobile terminals discussed above, show a very poor efficiency, particularly for low output powers. The efficiency $\eta$ of a transmission circuit is given by the equation

$$\eta = \frac{P_{out}}{P_{in} + P_{DC}} \qquad (1)$$

wherein $P_{out}$ is the RF output power provided by the power amplifier of the transmission circuit, $P_{in}$ is the RF input power supplied to the power amplifier for being amplified therein, and $P_{DC}$ is the DC power consumed by the respective transmission circuit.

A part of the consumed DC power $P_{DC}$ is converted to the RF output power $P_{out}$, the other part has to be considered as dissipation power. Most of the power is mainly dissipated in the MOS device used in transmission power control designs based on a control of the supply voltage $V_{cc}$. Other circuit designs preferring a gate power control for regulating the RF output power operate the power amplifier below saturation at poor efficiency. For this type of transmission control, the power is mainly dissipated in the power amplifier itself.

With the number of subscribers for wireless mobile telecommunication systems increasing, the density of base stations too is increased for more capacity. A denser network of base stations requires a transmitter of a mobile terminal to be generally operated at lower RF output powers. The described state of the art transmission control circuits for regulating the RF output power of mobile terminals shows a very poor efficiency especially for the low RF output power conditions. A reduction to a required RF low output power level does therefore not show up in an equivalent reduction of the energy supplied to the transmission circuit. In other words, the on-air time of a mobile terminal is not increased in the way as the required RF output power is lowered.

It is therefore an object of the present invention to provide a power controlled RF power transmission circuit for a mobile terminal with a high overall power efficiency.

This object is achieved by the invention as defined in the independent claim.

The above object is achieved by a high frequency power amplification circuit for a mobile terminal to be used in a wireless telecommunication system, with a high frequency transmit power amplifier operated across a DC operating voltage $V_{cc}$ for amplifying a high frequency input signal of input power of $P_{in}$ into a high frequency output signal of output power $P_{out}$, and a variable DC/DC converter for converting a DC input voltage $V_{bat}$ into a DC output voltage according to a first control signal $V_{ctr}$ applied to a control terminal of the same, wherein the DC output voltage of the variable DC/DC converter is provided to the high frequency transmit power amplifier as operating voltage $V_{cc}$ and the output power $P_{out}$ of the high frequency transmit power amplifier is controlled by means of the first control signal $V_{ctr}$.

Compared to MOS devices, a variable DC/DC converter transforms an input into an output voltage with a minimum of power dissipation. Furthermore, the value of the output voltage $V_{cc}$ can be higher as well as lower than the input voltage $V_{bat}$ supplied from the battery pack of the mobile terminal. The variable DC/DC converter thus combines the functions of a fixed DC/DC converter combined with a MOS device, without having to accept the high energy dissipation caused by the MOS device. The output voltage $V_{cc}$ can be regulated within a wide range by a control signal $V_{ctr}$ applied to the control terminal of the variable DC/DC converter. Simply built and thus cheap power amplifiers which operate at supply voltages $V_{cc}$ above the battery voltage available on a mobile terminal can therefore be used. The losses within the variable DC/DC converter do not increase with the reduction of the supply voltage $V_{cc}$ as it is true for MOS devices, and the power amplifier operates in saturation with a high efficiency. Thus, a very energy-efficient design for a power controlled transmission circuit is achieved, particularly when compared to the prior art transmission circuit designs.

Further developments are set forth in the dependent claims.

According to a preferred embodiment of the present invention, the first control signal $V_{ctr}$ is indicative of a target value of the output power $P_{out}$ in relation to an actual value of the output power $P_{ou}$ allowing a design of the transmission power control circuit as a closed loop control circuit.

In the above preferred embodiment, a control means compares further advantageously a reference signal indicative of a target value of the output power $P_{out}$ to a signal indicative of an actual value of the output power $P_{out}$ to provide the first control signal $V_{ctr}$ for generating an appropriate supply voltage $V_{cc}$ independent of the actual value of a battery voltage.

The control means advantageously provides a continuously variable first control signal $V_{ctr}$ to the variable DC/DC converter for a variable conversion of a DC input voltage $V_{bat}$ into the DC operating voltage $V_{cc}$, enabling a precise alignment of a RF output power $P_{out}$ with respect to a target value.

In a further preferred embodiment of the present invention, the control means further advantageously provides a stepwise variable first control signal $V_{ctr}$ to the variable DC/DC converter for a stepwise conversion of a DC input voltage $V_{bat}$ into discrete values of the DC operating voltage $V_{cc}$, allowing to adjust a RF output power for certain power ranges.

The high frequency transmit power amplifier of the above further preferred embodiment of the present invention is preferably equipped with a control terminal for controlling the output power $P_{out}$ of the same and the control means provides a second control signal $V_g$ for being applied to the control terminal for manipulating the output power $P_{out}$ within a range defined by a step of the DC operating voltage $V_{cc}$ thus allowing a fine tuning of the RF output power $P_{out}$ within the output power range set by a certain step of the operating voltage $V_{cc}$.

Next, the present invention will be explained in detail with respect to special embodiments and in relation to the attached figures, in which

Fig. 1a shows an operation of a power amplifier according to the prior art with a supply voltage controlled by a MOS device,

Fig. 1b shows an operation of a power amplifier according to the prior art with a supply voltage processed by a fixed DC/DC converter and controlled by MOS device,

Fig. 1c shows an operation of a power amplifier according to the prior art with direct battery supply and a gate power control of the RF output power,

Fig. 1d shows an operation of a power amplifier according to the prior art with a supply voltage processed by a fixed DC/DC converter and a gate power control of the RF output power,

Fig. 2 shows a first embodiment of the present invention using a variable DC/DC converter for regulating the supply voltage of a power amplifier in order to control the RF output power of the same,

Fig. 3 shows a second embodiment of the present invention using a variable DC/DC converter in a closed loop control circuit for continuously controlling the RF output power of a power amplifier, and

Fig. 4 shows a third embodiment of the present invention using a variable DC/DC converter in a closed loop control circuit for controlling the RF output power of a power amplifier within discrete ranges.

Like reference characters generally refer to the parts being technically of the same kind throughout the different views.

Prior art power control circuits for controlling a power $P_{out}$ of a RF output signal of a high frequency power amplifier 1 of a mobile terminal, like e.g. a mobile telephone, for use in a wireless telecommunication system according to e.g. the GSM or the UMTS standard are shown in Figs. 1a through 1d. The power amplifier 1 receives a RF signal $RF_{in}$ having a power $P_{in}$ and delivers an output signal $RF_{out}$ having a power $P_{out}$ to an antenna not shown for being transmitted therefrom. The power amplifier 1 is operated across supply voltage $V_{cc}$. An Automatic Power Control terminal provided on the power amplifier 1 enables a gate power control of the RF output power $P_{out}$ by applying an appropriate gate power control voltage $V_g$. The energy supply of the power control circuit is usually provided from a battery arrangement, which is e.g. part of a battery pack of the mobile terminal.

The power control circuits of Fig. 1a and 1b regulate the output power $P_{out}$ of the power amplifier 1 by varying the supply voltage $V_{cc}$. The circuit of Fig. 1a uses a MOS device 2 to controllably scale-down the battery voltage $V_{bat}$ to a value of $V_{cc}$ appropriate for the desired output power $P_{out}$. The fixed DC/DC converter 3 used in the control circuit shown in Fig. 1b is often used as a voltage stabiliser but is also very popular for producing voltages $V_{cc}$ higher than the battery voltage $V_{bat}$, which is particularly required for power amplifiers operating across voltages in the range of 5V to 6V in order to achieve maximum possible RF output power $P_{out}$. As for the first power control circuit described with reference to Fig. 1a, a MOS device 2 is used for controllably scaling down the voltage provided by the fixed DC/DC converter 3 to an appropriate voltage level $V_{cc}$ for adjusting the desired RF output power $P_{out}$.

In the control circuits shown in Fig. 1c and Fig. 1d, the power amplifier 1 is operated across a constant supply voltage $V_{cc}$. The RF output power is hereby controlled through application of an appropriate gate power control voltage $V_g$ to the Automatic Power Control terminal of the power amplifier 1. In a prior art circuit according to Fig. 1c the power amplifier is directly operated across a battery voltage $V_{bat}$. But to achieve the maximum possible RF output power $P_{out}$, a sophisticated and relatively expensive power amplifier has hereby to be used. When simpler and cheaper power amplifiers are used, which require a higher supply voltage $V_{cc}$ for the maximum possible power output, the transmit circuit will then be operated below the potential of its power amplifier. This is overcome by the design shown in Fig. 1d where a fixed DC/DC converter is used to stabilise the supply voltage $V_{cc}$ and if required, provide a voltage of an appropriately high value.

The efficiency of a transmit power control circuit is defined as the relation of the output signal power level $P_{out}$ to the sum of the input power levels. The sum of the input power levels is given by the RF input power $P_{in}$ plus the invested DC power $P_{DC}$ related to the supply voltage $V_{cc}$. As the RF output power $P_{out}$ is a multiple of the RF input power $P_{in}$, the efficiency $\eta$ of the transmit power control circuit is roughly given by the relation of the RF output power $P_{out}$ to the invested DC power $P_{DC}$:

$$\eta \approx \frac{P_{out}}{P_{DC}} \qquad (2)$$

whereby

$$P_{DC} - P_{out} = P_{dis} \qquad (3)$$

with $P_{dis}$ denoting the power dissipated within the transmit power control circuit.

Only a small amount of DC power is dissipated in the power amplifier 1 when it is operated in saturation according to the power control circuits shown in Fig. 1a and 1b. But a considerable amount of the energy supplied from the battery arrangement of the mobile terminal is consumed within the MOS device 2 when scaling down the battery voltage or the voltage provided by the fixed DC/DC converter 3, respectively. The efficiency of the power control circuit is thereby reduced considerably. When using a gate power control as shown in Figs. 1c and 1d, the power amplifier 1 is for low output powers $P_{out}$ operated in its linear operating region, which means that it is operated with a poor efficiency due to a high DC power dissipation within the power amplifier.

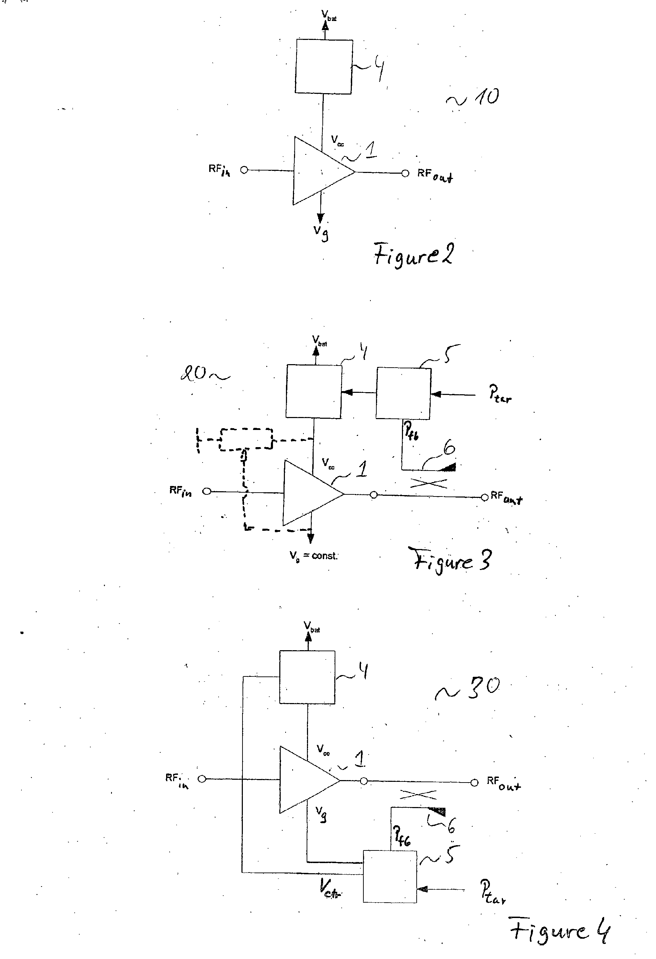

With respect to Fig. 2 a block diagram showing a first embodiment of a high frequency power amplification circuit for a mobile terminal to be used in a wireless telecommunication system is shown. The power amplifier 1 receives a RF signal $RF_{in}$ having a power $P_{in}$ and delivers the output signal $RF_{out}$ having a power $P_{out}$ to an antenna not shown for being transmitted therefrom. The power amplifier is operated in saturation, which means that the maximum output power with respect to a given supply voltage $V_{cc}$ is achieved. When operated in the saturation region, the power amplifier 1 produces a minimum of dissipated power. The value of the output power $P_{out}$ is controlled by the supply voltage $V_{cc}$ which can be increased or decreased with the variable DC/DC converter 4 in a continuous way. The power dissipation of the variable DC/DC converter 4 is a lot smaller than that produced by a MOS device used in the prior art. The power dissipation of a MOS device is given by the voltage drop across it multiplied with the supply current for the power amplifier 1. The variable DC/DC converter 4 enables a continuous control of the RF output power $P_{out}$ of the power amplifier 1 by varying the DC/DC converter's output voltage $V_{cc}$. Compared to the prior art, the maximum possible system efficiency is achieved over the whole RF power range, by combining the power amplifier 1 being operated in its most efficient state with the very energy-effective voltage conversion of the variable DC/DC converter 4. As $V_{cc}$ can take values greater than $V_{bat}$, the achievable RF output power $P_{out}$ is not limited by the value of the battery voltage $V_{bat}$.

With reference to Fig. 3 a usage of the variable DC/DC converter 4 within a closed loop RF output power control circuit according to the present solution is shown. A directional coupler 6 decouples a portion of the RF output power $P_{out}$ from the antenna supply line located between the output of the power amplifier 1 and the antenna of the mobile terminal. The respective decoupled portion $P_{fb}$ is fed to a controlling member 5 located in the feedback loop of the control circuit 20. The controlling member 5 compares $P_{fb}$ with $P_{tar}$ and generates $V_{ctr}$ based on the difference therebetween. $P_{tar}$ is indicative of the desired RF output power $P_{out}$ and is provided from the baseband side of the mobile terminal. $V_{ctr}$ represents a manipulated variable of the power control circuit 20, and is used for regulating the output voltage of the variable DC/DC converter 4 to obtain a desired value of the RF output power $P_{out}$.

The gate control voltage $V_g$ is hereby set to a constant value guaranteeing that the power amplifier 1 is operated in saturation. Some power amplifiers 1 hereto require that the gate control voltage $V_g$ has a fixed relation compared to the power supply voltage $V_{cc}$ instead of a constant value. An example for a respective provision of $V_g$ is indicated in Fig. 3 by a voltage divider represented in dashed lines.

The transmit power control circuit 20 shown in Fig. 3 enables a continuous adjustment of a RF output power according to a target value set from the base band side of a mobile terminal e.g. from a value taken from a look-up table.

An alternative design invention for a transmit power control circuit 30 according to the present is shown in Fig. 4. The power sensing control loop regulates the RF output power $P_{out}$ by combining the power control based on a variation of the supply voltage $V_{cc}$ with a gate power control. The target value for the output power is delivered to the control member 5 of the power sensing control loop from the basement side of the mobile terminal and therein compared to the signal $P_{fb}$ indicative of the actual RF output power $P_{out}$, which is provided by the directional coupler 6. The control member 5 compares $P_{fb}$, with $P_{tar}$ and generates $V_{ctr}$ based on the difference therebetween. Different to the embodiment shown in Fig. 3, $V_{ctr}$ is hereby not modified continuously according to the measured difference between $P_{fb}$ and $P_{tar}$, but takes in discrete values in a stepwise fashion. Accordingly, the variable DC/DC converter 4 converts the battery voltage $V_{bat}$ stepwise to certain discrete values for the supply voltage $V_{cc}$. Consequently, the RF output power $P_{out}$ can only take in certain discrete values which might differ from the target value $P_{tar}$. To achieve a concise fine tuning of the output power $P_{out}$, a gate power control is added. As distinguished from the control member 5 shown in Fig. 3, the control member shown in this embodiment produces a second control signal $V_g$ beside $V_{ctr}$. This second control signal $V_g$ is used for a gate power control of the power amplifier 1 to precisely adjust the RF output power $P_{out}$ within each range pre-set by the values set of two neighbouring $V_{ctr}$. The requirements for a variable DC/DC converter 4 are with a stepwise operation lower than when being operated in a continuous way, so that the production cost of a high efficiency transmit power control circuit 30 are lower than that for a control circuit 20. As distinct from a prior art gate power control circuit, the power amplifier 1 is still operated close to its saturation range, so that the power dissipation produced within the power amplifier itself is still very low.

As the power amplifier 1 is operated in saturation or very close to saturation, its maximum efficiency is used in the present invention. The overall efficiency of a transmit power control circuit according to the present invention is therefore given by the maximum power amplifier efficiency multiplied with the DC/DC converter efficiency, which is typically around 85%. This means, that over the whole output power range, a system efficiency close to 85% of the efficiency of the power amplifier is achieved, thus enabling longer on-air times for a respective mobile terminal transmitting with relatively low output power $P_{out}$.

**Claims**

1. A high-frequency power amplification circuit for a mobile terminal to be used in a wireless telecommunication system, comprising:

   a high-frequency transmit power amplifier (1) operated across a DC operating voltage $V_{cc}$ for amplifying a high-frequency input signal ($RF_{in}$) of input power $P_{in}$ into a high-frequency output signal ($RF_{out}$) of output power $P_{out}$, and
   a variable DC/DC converter (4) for converting a DC input voltage $V_{bat}$ into a DC output voltage according to a first control signal $V_{ctr}$ applied to a control terminal of the same,
   whereby the DC output voltage of the variable DC/DC converter (4) is provided to the high-frequency transmit power amplifier (1) as operating voltage $V_{cc}$ and the output power $P_{out}$ of the high-frequency transmit power amplifier (1) is controlled by means of said first control signal $V_{ctr}$.

2. A high-frequency power amplification circuit according to claim 1,
   **characterised in**
   **that** the first control signal $V_{ctr}$ is indicative of a target value of said output power $P_{out}$ in relation to an actual value of said output power $P_{out}$.

3. A high-frequency power amplification circuit according to claim 2,
   **characterised in**
   **that** a control means (5) compares a reference signal ($P_{tar}$) indicative of a target value of said output power $P_{out}$ to a signal ($P_{fb}$) indicative of an actual value of said output power $P_{out}$ to provide said first control signal $V_{ctr}$.

4. A high-frequency power amplification circuit according to claim 1, 2 or 3,
   **characterised in**
   **that** said control means (5) provides a continuously variable first control signal $V_{ctr}$ to the variable DC/DC converter (4) for a continuous variable conversion of a DC input voltage $V_{bat}$ into said DC operating voltage $V_{cc}$.

5. A high-frequency power amplification circuit according to claim 1, 2 or 3,

**characterised in**
**that** said control means (5) provides a stepwise variable first control signal $V_{ctr}$ to the variable DC/DC converter (4) for a stepwise variable conversion of a DC input voltage $V_{bat}$ into discreet values of said DC operating voltage $V_{cc}$.

6. A high-frequency power amplification circuit according to claim 5,
   **characterised in**
   **that** the high-frequency transmit power amplifier (1) comprises a control terminal for controlling the output power $P_{out}$ of the same, and that said control means (5) provides a second control signal $V_g$ for being applied to said control terminal for manipulating said output power $P_{out}$ within a range defined by a step of said DC operating voltage $V_{cc}$.

Figure 1

Figure 2

Figure 3

Figure 4

**European Patent Office**

**EUROPEAN SEARCH REPORT**

Application Number

EP 02 00 7188

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | HANINGTON G ET AL: "MICROWAVE POWER AMPLIFIER EFFICIENCY IMPROVEMENT WITH A 10 MHZ HBT DC-DC CONVERTER" 1998 IEEE MTT-S INTERNATIONAL MICROWAVE SYMPOSIUM DIGEST. IMS '98. PROGRESS THROUGH MICROWAVES. BALTIMORE, MD, JUNE 7 - 12, 1998, IEEE MTT-S INTERNATIONAL MICROWAVE SYMPOSIUM DIGEST, NEW YORK, NY: IEEE, US, vol. 2, 7 June 1998 (1998-06-07), pages 589-592, XP000822066 ISBN: 0-7803-4472-3 * page 590, left-hand column, last paragraph - right-hand column, last paragraph; figure 2 * --- | 1,2,4 | H03G3/00 H03G3/30 |
| X | US 2001/014613 A1 (BERGVELD HENDRIK J ET AL) 16 August 2001 (2001-08-16) * page 1, paragraph 18 - page 2, paragraph 25; figures 2,3 * ----- | 1-4 | |

TECHNICAL FIELDS SEARCHED (Int.Cl.7)

H03G

The present search report has been drawn up for all claims

| Place of search | Date of completion of the search | Examiner |
|---|---|---|
| THE HAGUE | 22 August 2002 | Blaas, D-L |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

EP 1 349 269 A1

## ANNEX TO THE EUROPEAN SEARCH REPORT
## ON EUROPEAN PATENT APPLICATION NO.

EP 02 00 7188

This annex lists the patent family members relating to the patent documents cited in the above-mentioned European search report.
The members are as contained in the European Patent Office EDP file on
The European Patent Office is in no way liable for these particulars which are merely given for the purpose of information.

22-08-2002

| Patent document cited in search report | Publication date | Patent family member(s) | Publication date |
|---|---|---|---|
| US 2001014613 A1 | 16-08-2001 | CN 1252184 T<br>EP 0960474 A2<br>WO 9931798 A2<br>JP 2001513972 T<br>US 6298222 B1 | 03-05-2000<br>01-12-1999<br>24-06-1999<br>04-09-2001<br>02-10-2001 |

EPO FORM P0459

For more details about this annex : see Official Journal of the European Patent Office, No. 12/82